# FASCICULE DE BREVET EUROPEEN

(11) **EP 3 547 027 B1**
(45) Date de publication et mention de la délivrance du brevet: **05.01.2022**
(21) Numéro de dépôt: 18165150.6
(22) Date de dépôt: 29.03.2018
(51) Int. Cl.: G03F 7/00, C25D 1/00, C25D 1/10, C25D 5/02, G03F 7/095

(54) **MÉTHODE DE FABRICATION D'UN MICROMOULE MULTI-NIVEAUX POUR ELECTROFORMAGE DE COMPOSANTS MICROMÉCANIQUES**
HERSTELLUNGSMETHODE EINER MEHRSTUFIGEN MIKROFORM FÜR DIE GALVANOFORMUNG VON MIKROMECHANISCHEN KOMPONENTEN
METHOD FOR MANUFACTURING A MULTI-LEVEL MICROMOULD FOR ELECTROFORMING MICROMECHANICAL COMPONENTS

(43) Date de publication de la demande: 02.10.2019
(73) Titulaire: Mimotec S.A., 1950 Sion (CH)
(72) Inventeur: LORENZ, Hubert, 1965 Savièse (CH); GENOLET, Grégoire, 1926 Fully (CH)
(74) Mandataire: Wenger, Joel-Théophile

(56) Documents cités:
- EP-A1- 0 851 295
- EP-A1- 2 053 146
- EP-A1- 2 157 476
- US-A1- 2007 202 560

## Description

La présente demande concerne le domaine de la fabrication de composants micromécaniques métalliques par électroformage en particulier des composants micromécaniques à plusieurs niveaux utilisés notamment dans l'horlogerie.

### Arrière-plan technique

Le procédé de fabrication de composants micromécaniques par irradiation d'une couche photosensible aux rayons ultraviolets suivie d'une étape d'électroformage est connu et est décrit dans la demande de brevet européenne No : EP18150436.6 avec No de publication EP3508916 A1.

Ce procédé est dérivé de la technique LIGA (Lithographie Galvanoformung Abformung) et consiste à :
- déposer sur un substrat une couche de 1 à 1000 µm d'une résine photosensible appelée photorésist,
- effectuer si nécessaire un aplanissage de la couche de photorésist par usinage mécanique,
- effectuer à travers un masque une irradiation au moyen d'un synchrotron ou par une exposition aux rayons ultraviolets,
- développer, c'est-à-dire éliminer par des moyens chimiques les portions de photorésist non polymérisées et créer de ce fait une cavité en photorésist,
- réaliser un dorage sélectif sur les surfaces supérieures de la cavité en photorésist dans le cas de la réalisation de cavité à plusieurs niveaux,
- répéter les étapes précédentes pour réaliser des cavités à plusieurs niveaux,
- électroformer un métal dans cette cavité afin d'obtenir le composant micromécanique.

L'avantage de cette technique est de réaliser des composants micromécaniques d'une très grande précision en X et Y et avec une épaisseur allant jusqu'à plusieurs millimètres. Il est également possible d'appliquer le procédé en plusieurs étapes pour obtenir un composant à plusieurs niveaux, chaque niveau étant construit sur le précédent.

Ce procédé est décrit plus avant dans la demande européenne No : EP18150436.6 et détaille le processus itératif des opérations de masquage, d'irradiation et de dissolution de la partie non irradiée.

Lorsque l'on souhaite obtenir des composants à plusieurs niveaux, l'homme du métier est confronté à des problèmes d'uniformité lors de l'électrodéposition qui peuvent prendre la forme de champignonnage ou de microcavités, par exemple. Ces problèmes limitent la réalisation de telles pièces. Ces problèmes sont inhérents à la croissance galvanique et sont causés en partie par la localisation de la couche conductrice nécessaire au dépôt galvanique, en particulier sur les flancs verticaux de la structure en photorésist résultant du procédé de dépose de la couche conductrice.

Afin de contourner ces obstacles, les différentes solutions s'attachent à empêcher le dépôt de la couche de matériau conducteur (de l'or ou du cuivre en général) sur les flancs verticaux de la structure en photorésist, afin que le métal électroformé ne se dépose sélectivement que sur les surfaces horizontales du photorésist.

Une première solution consiste à déposer l'or par une évaporation directionnelle parallèle aux flancs verticaux du photorésist afin que l'or ne se dépose pas sur ces flancs. On constate que l'obtention d'un faisceau parfaitement parallèle aux flancs verticaux est très difficile et que néanmoins une quantité d'or se fixe sur ces flancs de manière totale ou partielle.

Selon une autre solution connue, on applique un masque dont les ouvertures sont ajustées aux surfaces horizontales des reliefs, pour que l'or ne se dépose que sur ces parties horizontales (technique dite du « shadow mask »). Pour être efficace, l'ouverture doit être très légèrement inférieure à la surface horizontale afin d'empêcher toute diffusion parasite qui viendrait déposer des particules d'or sur les flancs verticaux. Cette technique nécessite un alignement parfait entre la pièce et le masque ce qui peut se révéler très difficile sur des pièces de taille moyenne ainsi que sur des substrats de grande taille. Cette technique ne permet pas d'isoler totalement toutes les géométries. Toutes les structures de masquage doivent en effet être reliées au cadre du masque et génèrent des masquages parasites.

Selon une troisième solution connue, on utilise un bain électrolytique comprenant des agents nivelants. Ces agents ont pour fonction de ralentir le dépôt de métal en certains endroits afin d'en homogénéiser l'épaisseur et sont donc uniquement adaptés pour limiter le champignonnage. Leur efficacité est extrêmement dépendante de la forme de la cavité et des paramètres d'électroformage.

Une quatrième solution consiste à structurer l'or évaporé supplémentaire à l'aide de la technique du « spray coating » et d'une attaque chimique de la couche conductrice non protégée. La couche conductrice évaporée sur l'ensemble du premier niveau photostructuré reçoit dans un premier temps une couche sprayée fine de photorésist. Une étape de photolithographie supplémentaire est nécessaire afin que subsiste une couche de masquage uniquement sur le dessus de la couche photostructurée. Ce masquage des faces horizontales permet d'attaquer chimiquement les couches conductrices déposées sur les flancs verticaux non-protégés. La technique de dépose de photorésist par spray coating ne permet pas d'obtenir des couches fines et uniformes, en particulier sur des topographies importantes avec des angles droits. Des effets de bord prononcés empêchent un dépôt uniforme. De plus, cette méthode nécessite l'utilisation d'une étape photolithographique complète supplémentaire avec l'utilisation d'un photomasque dont l'alignement est très critique.

Une cinquième solution consiste à déposer sélectivement une couche d'or sur les surfaces supérieures de chaque couche de photorésist après développement de chacune de celles-ci comme décrit dans la demande européenne EP18150436.6. L expérience a montré que la couche d or sur la première couche de photorésist peut provoquer un phénomène de réflexion parasite lors de 1 irradiation de la deuxième couche de photorésist. En effet, comme la couche d or s étend entièrement sur la surface supérieure de la première couche de photorésist, des parties de la couche d or se situant sur des surfaces situées sous la deuxième couche de photorésist provoquent des réflexions indésirables car le photorésist ne présente jamais une surface aussi homogène et lisse que le substrat de base.

Le document EP 0 851 295 décrit un procédé de fabrication de microstructure par conformation multicouche d une résine négative photosensible de type epoxy. Les microstructures sont réalisées en créant sur une plaquette-support un revêtement sacrificiel métallique et en structurant au moins deux couches de résine photosensible négative. Les couches structurées sont ensuite détachées de la plaquette-support en effectuant une attaque alcaline de la couche sacrificielle. Plusieurs techniques de fabrication de pièces multi-niveaux basées sur le procédé LIGA sont décrites dans des documents de 1 art antérieur, par exemple dans le document EP2157476A1. Ce document décrit un procédé de fabrication de pièces métalliques multi niveaux par la technologie UV-LIGA. Chaque couche de photorésist formant les niveaux de la pièce est creusée d'ouvertures formant un moule dans lequel est déposé par électroformage une couche métallique. Les pièces obtenues sont composées de niveaux formés dans un seul métal ou dans plusieurs métaux différents. Les différents niveaux de la cavité ne sont formés que dans des couches de photorésist superposées.

Le document EP 2 053 146 décrit un procédé de fabrication d'un moule d'électroformage, une première couche de résine photosensible est formée sur une surface supérieure d'un film conducteur inférieur 2 d'un substrat 1, et la première couche de résine photosensible 3 est divisée en une partie soluble 3b et une partie insoluble 3a. Un matériau conducteur est déposé ensuite thermiquement sur une surface supérieure de la première couche de résine photosensible dans une plage de températures dans laquelle de la lumière avec une longueur d'onde dans une plage ne provoquant pas de photoréaction dans la première couche de résine photosensible est émise pour former ainsi un film conducteur intermédiaire 5. Le film conducteur intermédiaire est structuré. Une seconde couche de résine photosensible 6 est formée sur une surface supérieure exposée de la première couche de résine photosensible après le retrait du film conducteur intermédiaire, et sur une surface supérieure du film conducteur intermédiaire restant après la configuration. La seconde couche de résine photosensible est divisée en une partie soluble 6b et une partie insoluble 6a. La première couche de résine photosensible et la seconde couche de résine photosensible sont développées et les parties solubles 3b et 6b sont éliminées. Ainsi, un moule d'électroformage 101 ayant un film conducteur au bas de chaque étage est obtenu.

Le document US2007/202560 décrit un réseau de microcanaux en résine comprenant un premier substrat comportant une pluralité de dépressions, chaque dépression comportant un orifice d'entrée à une extrémité et un orifice de sortie à une autre extrémité, et des parois coupant les dépressions, chaque paroi comportant une micro rainure reliant les dépressions, et une second substrat ayant une surface plate liée ou mise sous pression à une surface du premier substrat. Les espaces créés par les dépressions et les rainures dans une partie liée ou sous pression entre le premier substrat et le deuxième substrat servent de canaux d'écoulement. La largeur et la profondeur du canal d'écoulement sont comprises dans une plage allant de 1 à 50 um, et un rapport de la largeur et de la profondeur du canal d'écoulement est compris dans une plage allant de 1:10 à 10: 1.

Ces documents décrivent la réalisation de moules en photoresist multi-niveaux comprenant une métallisation uniquement sur les surfaces horizontales (voir en particulier le document EP 2 157 476). Néanmoins ce document est silencieux sur la manière de réaliser cette métallisation sélective.

### Description sommaire de 1 invention

Ces différentes techniques ne permettent que partiellement et difficilement d'obtenir des résultats satisfaisants. Le but de la présente invention est de proposer une méthode de fabrication de micromoules autorisant un dépôt par électroformage d une couche métallique homogène sur plusieurs niveaux.

Ce but est atteint par une méthode de fabrication de micromoules pour électroformage d un composant micromécanique métallique ayant au moins deux niveaux selon la revendication 1.

Cette invention permet la réalisation de micromoules à plusieurs niveaux incluant un dorage sélectif desquels résultent la fabrication de composants métalliques électroformés utilisés dans 1 horlogerie tels que des roues dentées, des ancres, des roues d ancres, des sautoirs ou tout autre composants micromécaniques.

Les micromoules obtenus par la méthode de 1 invention sont réalisés avec des photorésists liquides conventionnels mais aussi et avantageusement avec des photorésists secs.

### Description sommaire des figures

L'invention sera mieux comprise grâce à la description qui va suivre et qui se réfère aux dessins annexés donnés à titre d'exemple nullement limitatif, à savoir
La figure 1 illustre une étape d'irradiation à travers un premier photomasque et de polymérisation sélective d'une première couche de photorésist déposée sur un substrat recouvert d'une première couche conductrice.
La figure 2 illustre une étape de dépôt d'une deuxième couche de photorésist sur la première couche de photorésist polymérisé sélectivement.
La figure 3 illustre une étape d'irradiation à travers un deuxième photomasque et de polymérisation sélective de la deuxième couche de photorésist déposée sur la première couche de photorésist polymérisé sélectivement.
La figure 4 illustre le résultat obtenu après développement des deux couches de photorésist, les parties polymérisées formant un micromoule en photorésist.
La figure 5 illustre le micromoule de la figure 4 dont les surfaces horizontales des deux couches de photorésist et les flancs verticaux sont recouverts d'une deuxième couche conductrice.
La figure 6 illustre le micromoule obtenu selon la méthode de l'invention dans lequel la deuxième couche conductrice recouvre uniquement les surfaces horizontales visibles supérieures de la première et de la deuxième couche de photorésist polymérisé.
La figure 7 illustre une variante du micromoule dans laquelle la deuxième couche conductrice a été éliminée des surfaces horizontales supérieures de la deuxième couche de photorésist polymérisé.
La figure 8 illustre une vue en perspective du micromoule à deux niveaux de la figure 7.
La figure 9 illustre une vue en perspective d'un exemple de composant micromécanique d'horlogerie réalisée dans un micromoule à trois niveaux.

### Description détaillée de l'invention

Une particularité de l'invention est l'utilisation préférentielle d'une résine photosensible sèche de type négatif appelée ci-après « photorésist » sensible aux rayons ultraviolets UV, typiquement de la famille du SU-8 de MicroChem Corporation.

Le photorésist sec se présente généralement sous forme de feuilles, de granulés ou de poudre contenant un taux de solvant très faible en général inférieur ou égal à 5% et un photo-initiateur. Le dépôt de ce photorésist sec sur un substrat ou sur une autre couche de photorésist s'effectue à chaud à une température d'environ 80°C à laquelle le photorésist sec prend la consistance d'une pâte. La pâte peut être mise en forme sur un substrat par exemple par laminage ou par pressage entre deux plaques planes et parallèles, de manière à obtenir une couche plane d'épaisseur uniforme recouvrant le substrat.

L'utilisation du photorésist sec permet de bénéficier des avantages suivants par rapport à l'utilisation de photorésist conventionnel sous forme liquide :
- Un recuit servant à éliminer le solvant contenu dans le photorésist liquide n'est plus nécessaire.
- La densité de solvant dans les couches de photorésist est toujours stable et connue ce qui évite aux photomasques de coller contre la résine et produit des éléments photo-fabriqués plus précis.
- Le temps de séchage est quasi nul grâce au très faible taux de solvant. Le photorésist liquide nécessite un temps de séchage de plusieurs dizaines d'heures selon l'épaisseur de la couche. Le corollaire avantageux de cette invention est un temps de fabrication d'un micromoule à deux niveaux divisé par 4 à 5 par rapport à celui de l'art antérieur réalisé en photorésist liquide.
- Possibilité de réaliser une couche de grande épaisseur (plusieurs millimètres) en une seule étape de dépôt, le photorésist liquide nécessitant plusieurs étapes successives de dépôt avec des étapes de séchage intermédiaires de longue durée pour obtenir une même couche épaisse.

Une autre particularité de l'invention est le développement réalisé en une seule étape du micromoule à deux niveaux ou plus après dépôt, irradiation à travers un photomasque et polymérisation de chaque couche de photorésist définissant les niveaux du micromoule.

Après développement du micromoule, uniquement les surfaces horizontales supérieures et visibles des différents niveaux seront recouvertes d'une couche conductrice. Ce procédé particulier selon l'invention est décrit ci-après à l'aide des figures.

Le micromoule final se compose donc d'au moins deux niveaux s'étendant verticalement par rapport au substrat et dont les surfaces horizontales supérieures parallèles au substrat sont recouvertes d'une fine couche conductrice. Lors de l'électroformage, chaque fois que la couche métallique électroformée atteint la hauteur d'un de ces niveaux, la couche métallique est électriquement reliée au substrat et la croissance métallique se fait sur toute la surface horizontale supérieure de ce niveau.

### Explication de l'invention à l'aide des figures

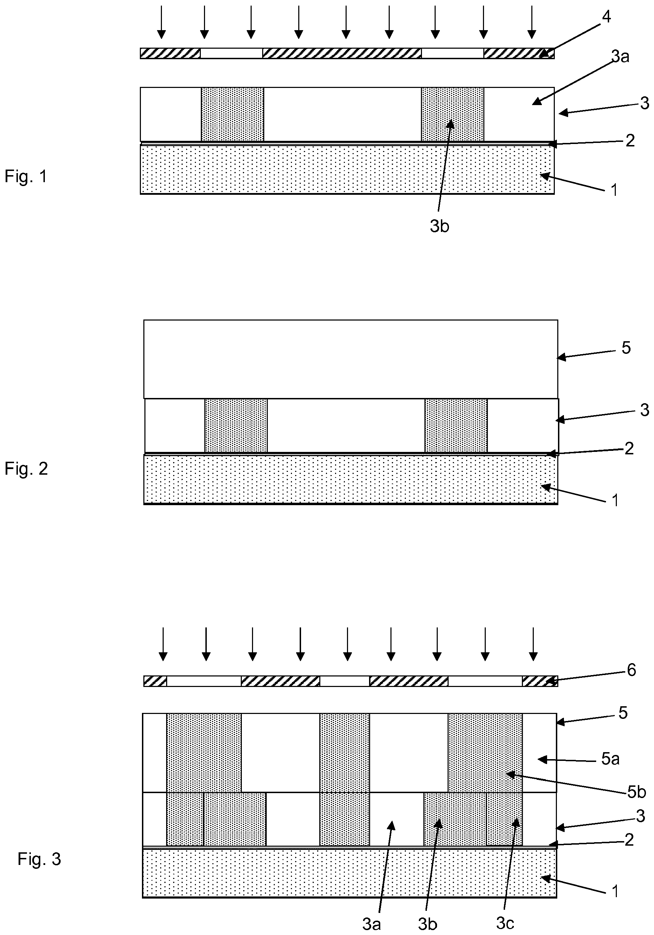

Selon la figure 1, le substrat 1 est généralement une plaque-support de verre, de métal ou de silicium sur laquelle est déposée une couche conductrice 2 réalisée par une évaporation de chrome et d'or, par exemple. Sur cette couche conductrice 2 est déposée une couche de photorésist 3 de type négatif.

Cette couche de photorésist 3 est sélectivement polymérisée après irradiation à travers un photomasque 4. Les parties 3b irradiées sont polymérisée tandis que les parties masquées 3a ne sont pas polymérisées.

L'irradiation utilise une technique de photolithographie par une source à ultraviolets ou à rayons X à travers une plaque en verre sur laquelle a été structuré un motif en chrome ou en or. Cette plaque avec sa découpe de chrome ou d'or est appelée un photomasque. La lumière illumine parfaitement perpendiculairement le photomasque, seules les parties 3b de photorésist non protégées par le motif en chrome sont irradiées.

La figure 2 montre la prochaine étape qui consiste à déposer une deuxième couche de photorésist 5 sur la première couche de photorésist 3 irradiée et polymérisée.

La figure 3 montre l'étape d'irradiation de cette deuxième couche de photorésist 5 à travers un deuxième photomasque 6. Les parties irradiées 5b de ladite deuxième couche 5 et des parties irradiées 3c de la première couche de photorésist 3 sont polymérisées en fonction du motif du photomasque 6 tandis que les parties 5a de ladite deuxième couche de photorésist 5 masquées ne sont pas polymérisées. Les parties 3a masquées à la fois par le premier photomasque 4 et par le deuxième photomasque 6 ne sont également pas polymérisées.

La première couche de photorésist 3 ainsi que la deuxième couche de photorésist 5 peuvent être aplanies après dépôt et avant l'étape d'irradiation de ces couches de photorésist. L'aplanissage est réalisé avantageusement par un procédé d'usinage appelé « fly-cutting » décrit ci-après.

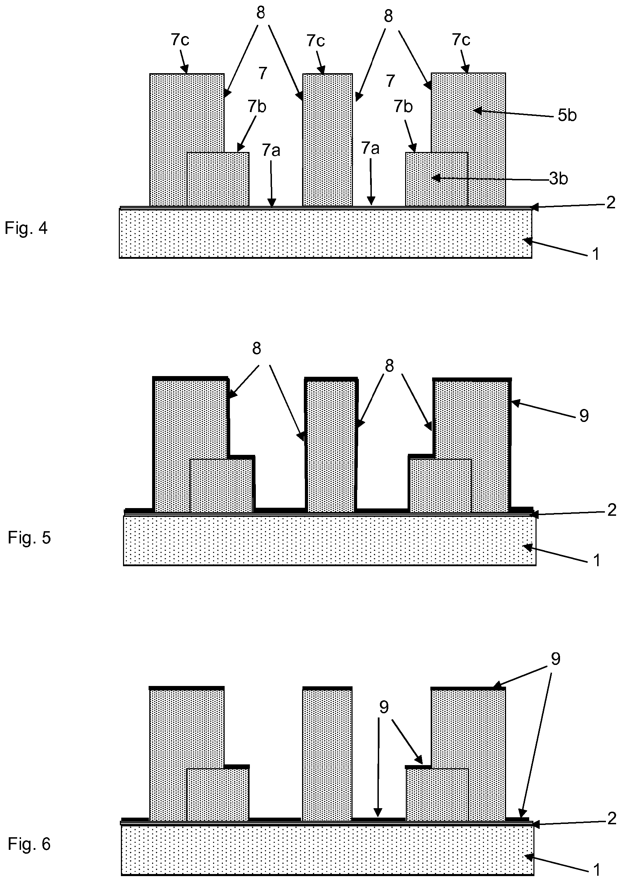

La figure 4 montre un micromoule en photorésist polymérisé obtenu après une étape de développement consistant à éliminer le photorésist non polymérisé et obtenir en relief dans le photorésist polymérisé les motifs présents sur les photomasques utilisé dans les étapes d'irradiation.

Lors de cette étape, toutes les parties non-polymérisées (3a, 5a) sont éliminées à l'aide d'un solvant tandis que les parties (3b, 3c, 5b) subsistent. Ce micromoule comporte ainsi une cavité 7 à deux niveaux horizontaux 7b et 7c et des flancs verticaux 8. Le fond 7a de la cavité 7 est constitué par la couche conductrice 2 recouvrant le substrat 1 tandis que le premier niveau est constitué par la première couche de photorésist 3 avec des surfaces horizontales supérieures 7b. Le deuxième niveau du micromoule est constitué par la deuxième couche de photorésist 5 avec des surfaces horizontales supérieures 7c.

La figure 5 montre le micromoule de la figure 4 entièrement recouvert par une deuxième couche conductrice 9. Cette deuxième couche conductrice 9, généralement constituée d'or, est déposée par une évaporation sous vide directionnelle parallèle aux flancs verticaux 8 de la cavité 7 afin de minimiser l'épaisseur de l'or déposé sur ces flancs verticaux 8.

La figure 6 montre le micromoule obtenu en éliminant la couche conductrice 9 recouvrant les flancs verticaux 8 de la cavité 7. Cette couche conductrice 9 est éliminée de ces flancs verticaux 8 afin d'éviter l'apparition de microcavités dans le métal électroformé comme évoqué dans la demande européenne EP18150436.6.

Seules les surfaces horizontales supérieures 7a du fond de la cavité, 7b du premier niveau et 7c du deuxième niveau sont recouvertes par la couche conductrice 9.

Comme la couche conductrice 9 est déposée après développement du micromoule en photorésist, le phénomène des réflexions parasites dues à une couche conductrice s'étendant sur les surfaces supérieures des parties polymérisée 3b de la première couche de photorésist 3 recouvertes par les parties polymérisées 5b de la deuxième couche de photorésist 5 disparaît. L'élimination de la couche conductrice sur les flancs verticaux 8 s'effectue par attaque chimique contrôlée. En effet, l'épaisseur de l'or déposé sur les flancs verticaux 8 est plus faible que celle de l'or déposé sur les surfaces horizontales 7a, 7b et 7c. De ce fait, la couche d'or est éliminée en premier sur ces flancs verticaux 8 tandis qu'une épaisseur d'or suffisante à la conduction électrique subsiste sur les surfaces horizontales supérieures 7a, 7b et 7c du micromoule. Cette variante de micromoule avec une couche conductrice 9 sur les surfaces supérieures 7c de la deuxième couche de photorésist polymérisé 5b est en général utilisée pour la fabrication de moules métalliques pour injection de matière plastique. En effet, la couche conductrice 9 sur les surfaces supérieures 7c de la deuxième couche de photorésist polymérisé 5b permet un débordement du métal électroformé dans la cavité 7 de manière à recouvrir entièrement ces surfaces supérieures 7c. Une étape d'usinage permet d'obtenir une épaisseur prédéterminée du métal recouvrant les surfaces conductrices 7c. L'épaisseur totale du métal électroformé est dans ce cas supérieure à la profondeur maximale de la cavité 7. En éliminant le micromoule en photorésist polymérisé et le substrat on obtient un moule métallique pour injection comportant au moins un relief ayant une forme correspondant à celle de la cavité 7.

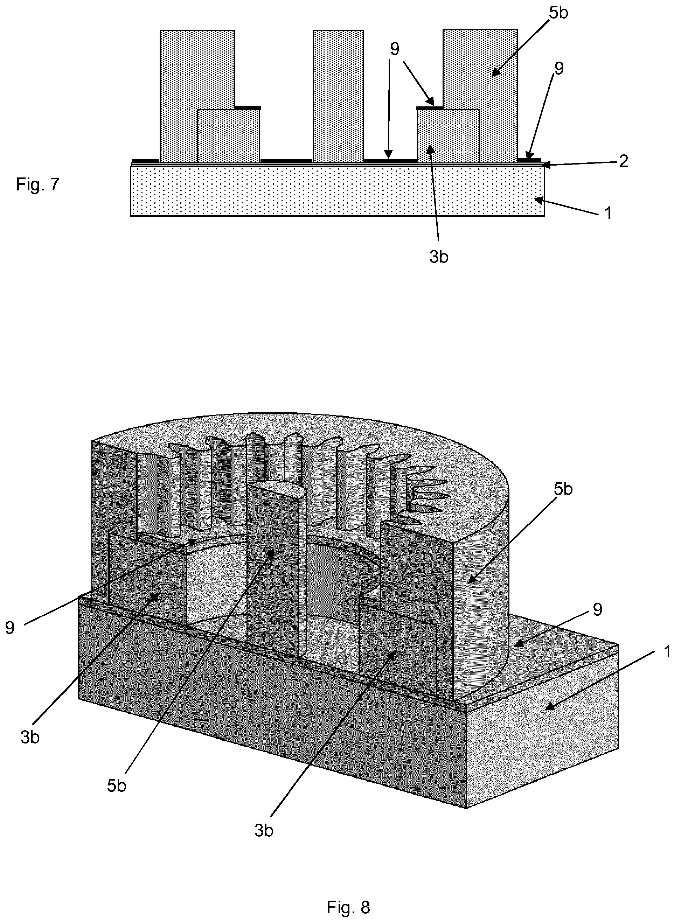

La figure 7 montre une variante du micromoule de la figure 6 dans laquelle la couche d'or recouvrant les surfaces horizontales 7c de la deuxième couche de photorésist 5 a été neutralisée de manière à la rendre non conductrice. Cette variante de micromoule est en général utilisée pour la fabrication de composants micromécaniques d'horlogerie ayant une épaisseur maximale égale à la profondeur maximale de la cavité 7. Le métal électroformé ne déborde pas sur les surfaces supérieures 7c de la deuxième couche de photorésist polymérisé 5b comme dans le cas précédent.

Ce micromoule est disposé sur un substrat 1 ayant une surface recouverte d'une couche conductrice 2. Il comprend une cavité 7 comportant au moins deux niveaux horizontaux. La cavité comprend un fond conducteur, un premier niveau en photorésist 3 d'une première épaisseur prédéfinie déposé sur le substrat 1. Le premier niveau comporte une première ouverture ayant un premier contour prédéfini et des flancs verticaux 8 reliant le premier contour au fond 7a de la cavité et un deuxième niveau en photorésist 5 d'une deuxième épaisseur prédéfinie déposé sur le premier niveau. Le deuxième niveau comporte une deuxième ouverture en aplomb de la première ouverture, la deuxième ouverture ayant un deuxième contour englobant le premier contour et des flancs verticaux 8 reliant le deuxième contour à une surface horizontale supérieure 7b du premier niveau et/ou le fond 7a de la cavité. Le micromoule est caractérisé en ce que les surfaces horizontales supérieures visibles 7b du premier niveau de la cavité 7 sont recouvertes d'une couche conductrice 9 s'étendant entre le premier contour et le deuxième contour. Autrement dit, cette couche conductrice 9 s'étend uniquement sur les surfaces horizontales supérieures 7b du premier niveau de la cavité 7 qui sont visibles, les flancs verticaux 8 étant exempts de couche conductrice 9.

La couche d'or recouvrant les surfaces horizontales 7c peut être neutralisée par usinage, par recouvrement d'une matière isolante à l'aide d'un tampon ou par attaque chimique contrôlée.

L'usinage des surfaces horizontales de la deuxième couche de photorésist dans le but d'éliminer la couche d'or peut être réalisé par un procédé connu sous le nom de « fly-cutting » utilisant un outil de coupe muni d'une extrémité coupante en métal dur, céramique, carbure métallique, nitrure métallique ou en diamant. Le document publié en octobre 2006 et intitulé : A new UV lithography photoresist based on composite of EPON resins 165 and 154 for fabrication of high-aspect-ratio microstructures, Ren Yang Et al. Department of Mechanical Engineering, Louisiana State University, 2513B CEBA, Baton Rouge, LA 70803, United States mentionne l'utilisation du « fly-cutting » dans le domaine de l'usinage de précision ou d'aplanissage de couches de photorésist.

Le recouvrement de la couche d'or peut s'effectuer par transfert sélectif d'une matière isolante sur les surfaces horizontales de la deuxième couche de photorésist au moyen d'un tampon. Le document intitulé «Non-Photolithographic Methods for Fabrication of Elastomeric Stamps for Use in Microcontact Printing », de Younan Xia, Joe Tien, Dong Qin, and George M. Whitesides, Department of Chemistry, Harvard University, Cambridge, Massachusetts 02138 décrit des méthodes de fabrication de tampons et de dépôt d'une couche isolante. Un autre document des mêmes auteurs intitulé : « Microcontact Printing of SAMs» décrit des méthodes d'impression de couches isolantes structurées sur des surfaces métalliques en utilisant des tampons enduits d'un alkanéthiolate.

L'attaque chimique contrôlée peut être réalisée en remplissant la cavité 7 du micromoule par une matière de protection de manière à recouvrir la couche conductrice du fond et du premier niveau de la cavité et ne laisser subsister que la couche conductrice 9 sur les surfaces horizontales 7c du deuxième et dernier niveau. Cette couche conductrice 9 peut ainsi être éliminée sans attaquer les couches conductrices du premier niveau et du fond de la cavité. La matière de protection est également éliminée en utilisant un solvant approprié.

La figure 8 représente une vue en perspective d'un micromoule coupé en sa moitié permettant l'électroformage d'une roue dentée et d'un rehaut circulaire. La couche 5b représente le micromoule de la roue dentée avec une structure centrale qui définira un trou d'assemblage pour un axe. La couche 3b représente le micromoule du rehaut circulaire.

### Variantes avec différents types de photorésist sec et/ou liquide

Selon une variante de la méthode, la première couche de photorésist 3 est formée par un photorésist sec de type négatif pressé et mis en forme à chaud en une couche d'épaisseur uniforme sur la première couche conductrice 2 recouvrant le substrat 1.

Selon une variante de la méthode, la première couche de photorésist 3 peut être formée par un photorésist liquide de type négatif réparti en une couche d'épaisseur uniforme sur la première couche conductrice 2 recouvrant le substrat 1.

Selon une autre variante, la deuxième couche de photorésist 5 peut être formée par un photorésist sec de type négatif pressé et mis en forme à chaud en une couche d'épaisseur uniforme sur la première couche de photorésist 3. Cette première couche 3 étant constituée de photorésist déposé sous forme sèche ou liquide.

Selon une autre variante, la deuxième couche de photorésist 5 peut être formée par un photorésist liquide de type négatif réparti en une couche d'épaisseur uniforme sur la première couche de photorésist 3. Cette première couche 3 étant constituée de photorésist déposé sous forme sèche ou liquide.

Dans le cas d'un dépôt d'une couche de photorésist liquide, des étapes de séchage et de recuit sont nécessaires avant les étapes d'irradiation à travers un photomasque et de polymérisation des parties irradiées.

Les variantes utilisant uniquement des photorésists liquides pour les différentes couches produisent des cavités moins reproductibles.
- Après séchage et recuit de la première couche 3 des résidus de solvant peuvent persister dans le photorésist. Lors du séchage des couches de photorésist supérieures, ces résidus de solvant variables peuvent migrer et diffuser à l'intérieur des couches non polymérisées.
- La densité de solvant résiduelle dans le photorésist est moins maîtrisée et il en découle des cavités photo-fabriquées moins reproductibles.
- Les photomasques ont tendance à coller contre la couche de photorésist ce qui induit également des cavités photo-fabriquées moins précises.

### Fabrication de cavités à plus de deux niveaux.

La fabrication de micromoule à plus de deux niveaux est également possible par le procédé de l'invention. En effet, des étapes successives supplémentaires de dépôt, irradiation à travers un photomasque et polymérisation d'une couche de photorésist peuvent être répétées après l'étape de dépôt, irradiation et polymérisation de la deuxième couche de photorésist. Autrement dit, il faudra effectuer autant d'étapes de dépôt, irradiation et polymérisation d'une couche de photorésist qu'il y aura de niveaux au micromoule final.

Comme dans le cas de la fabrication du micromoule à deux niveaux, des étapes supplémentaires d'aplanissage peuvent être effectuées après dépôt et avant l'irradiation de chaque couche de photorésist.

Le développement du micromoule en photorésist polymérisé est réalisé en une seule fois lorsque toutes les étapes de dépôt, irradiation et polymérisation de couches de photorésist de chaque niveau ont été effectuées.

La deuxième couche conductrice 9 est déposée sur les surfaces horizontales supérieures de chaque niveau de la même manière que dans le cas du micromoule à deux niveaux. La couche conductrice recouvrant les surfaces horizontales supérieures du dernier niveau peut être éliminée ou non en fonction de l'application finale du micromoule. La couche d'or sur les flancs verticaux est éliminée selon la méthode précédemment décrite.

Le micromoule à plus de deux niveaux ainsi obtenu comporte une cavité dans laquelle chaque niveau en photorésist comporte une ouverture en aplomb d'un niveau immédiatement inférieur. Cette ouverture a un contour englobant le contour de l'ouverture du niveau immédiatement inférieur et des flancs verticaux reliant cette ouverture à une surface horizontale d'un ou plusieurs niveaux inférieurs et ou le fond de la cavité. Au moins les surfaces horizontales supérieures visibles de chaque niveau inférieur au dernier niveau de la cavité sont recouvertes d'une couche conductrice 9, les flancs verticaux 8 étant exempts de couche conductrice 9.

Comme dans le cas du micromoule à deux niveaux, les surfaces horizontales supérieures du dernier niveau peuvent être recouvertes par la deuxième couche conductrice 9.

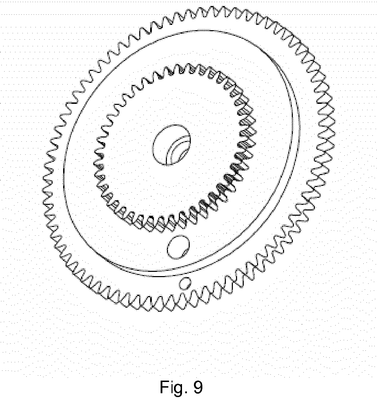

La figure 9 montre un exemple de composant micromécanique métallique d'horlogerie à trois niveaux réalisé dans un micromoule fabriqué selon la méthode de l'invention.

La méthode de l'invention permet également de fabriquer en même temps une pluralité de micromoules à deux niveaux ou plus disposés sur un substrat ayant une surface recouverte d'une couche conductrice. Les micromoules peuvent être disposés sur tout ou partie de la surface du substrat. Le substrat comprenant un ensemble de micromoules est appelé plaque support ou wafer.

## Revendications

1. Méthode de fabrication de micromoules pour électroformage d un composant micromécanique ayant au moins deux niveaux, cette méthode comprenant les étapes suivantes :
a) déposer et irradier au travers d'un premier photomasque (4), une première couche de photorésist (3) appliquée sur un substrat (1) recouvert d'une première couche conductrice (2), ladite première couche de photorésist (3) définissant un premier niveau du micromoule,
b) polymériser la première couche de photorésist (3),
c) déposer et irradier au travers d'un deuxième photomasque (6), une deuxième couche de photorésist (5) appliquée sur la première couche de photorésist (3) ladite deuxième couche de photorésist (5) définissant un
deuxième niveau du micromoule,
d) polymériser la deuxième couche de photorésist (5),
e) éliminer le photorésist non polymérisé (3a, 5a) de la première couche de photorésist (3) et de la deuxième couche de photorésist (5),
f) obtention d un micromoule à deux niveaux en photorésist polymérisé (3b, 3c et 5b) comprenant au moins une cavité (7) comportant un fond formé par la première couche conductrice (2) recouvrant le substrat (1), des surfaces horizontales supérieures du premier niveau (7b) et des flancs verticaux (8),
g) déposer une deuxième couche conductrice d'or (9) sur le fond de la cavité (7a), sur les surfaces horizontales supérieures du premier niveau (7b), sur les surfaces horizontales supérieures du deuxième niveau (7c) et sur les flancs verticaux (8) de la cavité (7), **par une évaporation sous vide directionnelle parallèle aux flancs verticaux (8) de la cavité (7) afin de minimiser I épaisseur de I or déposé sur ces flancs verticaux (8), I épaisseur de I or déposée sur les flancs verticaux (8) étant plus faible que celle de I or déposée sur les surfaces horizontales (7a, 7b et 7c),**
h) élimination de la deuxième couche conductrice (9) recouvrant les flancs verticaux (8) de la cavité (7) **par attaque chimique contrôlée,** ladite deuxième couche conductrice (9) recouvrant uniquement le fond de la cavité (7a) et les surfaces horizontales supérieures du premier et du deuxième niveau (7b, 7c).

2. Méthode selon la revendication 1 **caractérisée en ce que** la première couche de photorésist (3) est formée par un photorésist sec de type négatif pressé et mis en forme à chaud en une couche d épaisseur uniforme sur la première couche conductrice (2) recouvrant le substrat (1).

3. Méthode selon la revendication 1 **caractérisée en ce que** la première couche de photorésist (3) est formée par un photorésist liquide de type négatif réparti en une couche d épaisseur uniforme sur la première couche (2) conductrice recouvrant le substrat (1).

4. Méthode selon I une quelconque des revendications 1 à 3 **caractérisée en ce que** la deuxième couche de photorésist (5) est formée par un photorésist sec de type négatif pressé et mis en forme à chaud en une couche d épaisseur uniforme sur la première couche de photorésist (3).

5. Méthode selon I une quelconque des revendications 1 à 3 **caractérisée en ce que** la deuxième couche de photorésist (5) est formée par un photorésist liquide de type négatif réparti en une couche d épaisseur uniforme sur la première couche de photorésist (3).

6. Méthode selon I une quelconque des revendications 1 à 5 **caractérisée en ce qu** elle comprend des étapes supplémentaires d aplanissage de la première et/ou de la deuxième couche de photorésist (3, 5) après dépôt et précédant I étape d irradiation desdites couches de photorésist (3, 5).

7. Méthode selon I une quelconque des revendications 1 à 6 **caractérisée en ce qu** elle comprend une étape supplémentaire de neutralisation de la deuxième couche conductrice (9) recouvrant les surfaces horizontales supérieures (7c) du deuxième niveau, ladite neutralisation étant réalisée par usinage, recouvrement par une couche de matière isolante ou attaque chimique contrôlée.

8. Méthode de fabrication de micromoules pour électroformage d un composant micromécanique ayant plus de deux niveaux, caractérisée en qu elle comprend des étapes successives supplémentaires aux étapes a) à d) de la revendication 1 de dépôt de couches de photorésist, irradiation à travers un photomasque et polymérisation des parties irradiées précédant I étape e) d élimination du photorésist non polymérisé de chaque couche de photorésist déposée, les étapes g) et h) de dépôt de la deuxième couche conductrice et d élimination de ladite couche conductrice sur les flancs verticaux de la cavité étant effectuées après I étape e), le micromoule obtenu comportant autant de niveaux que de couches de photorésist préalablement déposées, irradiées et polymérisées.

9. Méthode selon la revendication 8 **caractérisée en ce qu** elle comprend des étapes supplémentaires d aplanissage d au moins une couche de photorésist après dépôt et précédant I étape d irradiation de ladite couche de photorésist.

10. Méthode selon la revendication 8 ou 9 **caractérisée en ce qu** elle comprend une étape supplémentaire de neutralisation de la deuxième couche conductrice (9) recouvrant les surfaces horizontales supérieures du dernier niveau, ladite neutralisation étant réalisée par usinage, recouvrement par une couche de matière isolante ou attaque chimique contrôlée.

## Patentansprüche

1. Verfahren zur Herstellung von Mikroformen für die Galvanoformung eines mikromechanischen Bauteils mit mindestens zwei Ebenen, wobei das Verfahren die folgenden Schritte umfasst:
a) Abscheidung und Bestrahlung durch eine erste Fotomaske (4) einer ersten Fotoresistschicht (3), die auf einem mit einer ersten leitenden Schicht (2) bedeckten Substrat (1) aufgebracht ist, wobei die erste Fotolackschicht (3) eine erste Ebene der Mikroform definiert,
b) Polymerisieren der ersten Fotoresistschicht (3)
c) Abscheidung und Bestrahlung einer zweiten Fotoresistschicht (5), die auf der ersten Fotoresistschicht (3) aufgebracht ist, durch eine zweite Fotomaske (6), wobei die zweite Fotoresistschicht (5) eine zweite Ebene der Mikroform definiert
d) Polymerisieren der zweiten Fotoresistschicht (5),
e) Entfernen des unpolymerisierten Fotoresists (3a, 5a) von der ersten Fotoresistschicht (3) und der zweiten Fotoresistschicht (5),
f) Herstellen einer zweistufigen Mikroform aus polymerisiertem Fotoresist (3b, 3c und 5b), die mindestens einen Hohlraum (7) mit einem Boden, der durch die erste leitende Schicht (2) gebildet wird, die das Substrat (1) bedeckt, oberen horizontalen Flächen der ersten Stufe (7b) und vertikalen Flanken (8) umfasst
g) Aufbringen einer zweiten leitfähigen Goldschicht (9) auf dem Boden des Hohlraums (7a), auf den oberen horizontalen Flächen der ersten Ebene (7b), auf den oberen horizontalen Flächen der zweiten Ebene (7c) und auf den vertikalen Flanken (8) des Hohlraums (7) durch gerichtete Vakuumverdampfung parallel zu den vertikalen Flanken (8) des Hohlraums (7), um die Dicke des auf diesen vertikalen Flanken (8) abgeschiedenen Goldes zu minimieren, wobei die Dicke des auf den vertikalen Flanken (8) abgeschiedenen Goldes geringer ist als die des auf den horizontalen Oberflächen (7a, 7b und 7c) abgeschiedenen Goldes,
h) Entfernung der zweiten leitenden Schicht (9), die die vertikalen Seiten (8) des Hohlraums (7) bedeckt, durch kontrolliertes Ätzen, wobei die zweite leitende Schicht (9) nur den Boden des Hohlraums (7a) und die oberen horizontalen Flächen der ersten und zweiten Ebene (7b, 7c) bedeckt.

2. Verfahren nach Anspruch 1, **dadurch gekennzeichnet, dass** die erste Fotoresistschicht (3) durch einen trockenen Fotoresist vom Negativtyp gebildet wird, der auf die erste leitende Schicht (2), die das Substrat (1) bedeckt, gepresst und durch Wärme zu einer Schicht mit gleichmäßiger Dicke geformt wird.

3. Verfahren nach Anspruch 1, **dadurch gekennzeichnet, dass** die erste Fotoresistschicht (3) durch einen flüssigen Fotoresist vom negativen Typ gebildet wird, der in einer Schicht gleichmäßiger Dicke über die erste leitende Schicht (2), die das Substrat (1) bedeckt, verteilt ist.

4. Verfahren nach einem der Ansprüche 1 bis 3, **dadurch gekennzeichnet, dass** die zweite Fotoresistschicht (5) durch einen trockenen Fotoresist vom Negativtyp gebildet wird, der in eine Schicht gleichmäßiger Dicke auf die erste Fotoresistschicht (3) gepresst und durch Wärme geformt wird.

5. Verfahren nach einem der Ansprüche 1 bis 3, **dadurch gekennzeichnet, dass** die zweite Fotoresistschicht (5) durch einen flüssigen Fotoresist vom negativen Typ gebildet wird, der in einer Schicht mit gleichmäßiger Dicke auf der ersten Fotoresistschicht (3) verteilt ist.

6. Verfahren nach einem der Ansprüche 1 bis 5, **dadurch gekennzeichnet, dass** es zusätzliche Schritte der Planarisierung der ersten und/oder zweiten Fotoresistschicht (3, 5) nach der Abscheidung und vor dem Schritt der Bestrahlung der Fotoresistschichten (3, 5) umfasst.

7. Verfahren nach einem der Ansprüche 1 bis 6, **dadurch gekennzeichnet, dass** es einen zusätzlichen Schritt der Neutralisierung der zweiten leitenden Schicht (9) umfasst, die die oberen horizontalen Flächen (7c) der zweiten Ebene bedeckt, wobei die Neutralisierung durch Bearbeitung, Bedeckung mit einer Schicht aus isolierendem Material oder kontrolliertes chemisches Ätzen erfolgt.

8. Verfahren zur Herstellung von Mikroformen für die Galvanoplastik eines mikromechanischen Bauteils mit mehr als zwei Ebenen, **dadurch gekennzeichnet, dass** es zusätzlich zu den Schritten a) bis d) des Anspruchs 1 die aufeinanderfolgenden Schritte des Auftragens von Fotoresistschichten, des Bestrahlens durch eine Fotomaske und des Polymerisierens der bestrahlten Teile vor dem Schritt e) des Entfernens des nichtpolymerisierten Fotoresist von jeder aufgetragenen Fotoresistschicht umfasst, die Schritte g) und h) des Auftragens der zweiten leitenden Schicht und des Entfernens der genannten leitenden Schicht auf den vertikalen Seiten des Hohlraums werden nach dem Schritt e) durchgeführt, wobei die erhaltene Mikroform so viele Ebenen umfasst, wie es zuvor aufgetragene, bestrahlte und polymerisierte Fotoresistschichten gibt.

9. Verfahren nach Anspruch 8, **dadurch gekennzeichnet, dass** es zusätzliche Schritte der Planarisierung mindestens einer Fotoresistschicht nach der Abscheidung und vor dem Schritt der Bestrahlung der Fotoresistschicht umfasst.

10. Verfahren nach Anspruch 8 oder 9, **dadurch gekennzeichnet, dass** es einen zusätzlichen Schritt umfasst, bei dem nicht

## Claims

1. A method of manufacturing micromolds for electroforming a micromechanical component having at least two levels, said method comprising the following steps:
a) depositing and irradiating through a first photomask (4), a first photoresist layer (3) applied on a substrate (1) covered by a first conductive layer (2), said first photoresist layer (3) defining a first level of the micromold,
b) polymerizing the first photoresist layer (3)
c) depositing and irradiating through a second photomask (6) a second photoresist layer (5) applied on the first photoresist layer (3), said second photoresist layer (5) defining a second level of the micromold
d) polymerizing the second photoresist layer (5)
e) removing the unpolymerized photoresist (3a, 5a) from the first photoresist layer (3) and from the second photoresist layer (5)
f) obtaining a two-level micromold of polymerized photoresist (3b, 3c and 5b) comprising at least one cavity (7) having a bottom formed by the first conductive layer (2) covering the substrate (1), upper horizontal surfaces of the first level (7b) and vertical flanks (8)
g) depositing a second conductive gold layer (9) on the bottom of the cavity (7a), on the upper horizontal surfaces of the first level (7b), on the upper horizontal surfaces of the second level (7c) and on the vertical sides (8) of the cavity (7) by a directional vacuum evaporation parallel to the vertical flanks (8) of the cavity (7) in order to minimize the thickness of the gold deposited on these vertical flanks (8), the thickness of the gold deposited on the vertical flanks (8) being smaller than that of the gold deposited on the horizontal surfaces (7a, 7b and 7c),
h) removal of the second conductive layer (9) covering the vertical sides (8) of the cavity (7) by controlled etching, said second conductive layer (9) covering only the bottom of the cavity (7a) and the upper horizontal surfaces of the first and second level (7b, 7c).

2. The method according to claim 1 **characterized in that** the first photoresist layer (3) is formed by a negative type dry photoresist pressed and heat-formed into a layer of uniform thickness on the first conductive layer (2) covering the substrate (1).

3. The method according to claim 1, **characterized in that** the first photoresist layer (3) is formed by a negative type liquid photoresist distributed in a layer of uniform thickness on the first conductive layer (2) covering the substrate (1).

4. The method according to any one of claims 1 to 3, **characterized in that** the second photoresist layer (5) is formed by a dry negative-type photoresist pressed and heat-formed into a layer of uniform thickness on the first photoresist layer (3).

5. The method according to any one of claims 1 to 3, **characterized in that** the second photoresist layer (5) is formed by a liquid negative-type photoresist distributed in a layer of uniform thickness on the first photoresist layer (3).

6. Method according to any one of claims 1 to 5, **characterized in that** it comprises additional steps of planarizing the first and/or second photoresist layer (3, 5) after deposition and preceding the step of irradiating said photoresist layers (3, 5).

7. Method according to any one of claims 1 to 6, **characterized in that** it comprises an additional step of neutralizing the second conductive layer (9) covering the upper horizontal surfaces (7c) of the second level, said neutralization being carried out by machining, covering by a layer of insulating material or controlled chemical etching.

8. Method of manufacturing micromolds for electroforming a micromechanical component having more than two levels, **characterized in that** it comprises successive steps additional to steps a) to d) of claim 1 of depositing layers of photoresist, irradiation through a photomask and polymerization of the irradiated parts preceding step e) of removing the unpolymerized photoresist from each deposited layer of photoresist, the steps g) and h) of depositing the second conductive layer and removing said conductive layer on the vertical sides of the cavity being carried out after step e), the micromold obtained comprising as many levels as there are previously deposited, irradiated and polymerized photoresist layers.

9. The method of claim 8, **characterized in that** it comprises additional steps of planarizing at least one photoresist layer after deposition and preceding the step of irradiating said photoresist layer.

10. Method according to claim 8 or 9, **characterized in that** it comprises an additional step of neutralizing the second conductive layer (9) covering the upper horizontal surfaces of the last level, said neutralization being performed by machining, covering with a layer of insulating material or controlled chemical etching.
